Europäisches Patentamt

European Patent Office

Office européen des brevets

(19)

(11) **EP 1 057 264 B1**

(12) **FASCICULE DE BREVET EUROPEEN**

(45) Date de publication et mention
de la délivrance du brevet:
**05.06.2002 Bulletin 2002/23**

(51) Int Cl.⁷: **H03L 1/02**, H03K 3/011,
H03K 3/0231

(21) Numéro de dépôt: **99900428.6**

(22) Date de dépôt: **21.01.1999**

(86) Numéro de dépôt international:
**PCT/CH99/00028**

(87) Numéro de publication internationale:
**WO 99/38260 (29.07.1999 Gazette 1999/30)**

(54) **OSCILLATEUR COMPENSE EN TEMPERATURE**

TEMPERATURKOMPENSIERTER OSZILLATOR

TEMPERATURE COMPENSATED OSCILLATOR

(84) Etats contractants désignés:
**AT BE CH DE FR GB IE IT LI NL**

(30) Priorité: **23.01.1998 WOPCT/CH98/00024**

(43) Date de publication de la demande:
**06.12.2000 Bulletin 2000/49**

(73) Titulaire: **EM Microelectronic-Marin SA
2074 Marin (CH)**

(72) Inventeur: **DIVOUX, Jean-No[l
CH-2300 La Chaux-de-Fonds (CH)**

(74) Mandataire: **Laurent, Jean et al
I C B
Ingénieurs Conseils en Brevets SA
Rue des Sors 7
CH-2074 Marin (CH)**

(56) Documents cités:
**DE-A- 4 340 924        US-A- 5 180 995
US-A- 5 448 103        US-A- 5 604 467
US-A- 5 699 024**

• **PATENT ABSTRACTS OF JAPAN vol. 011, no.
065 (E-484), 27 février 1987 & JP 61 224447 A
(YOKOGAWA ELECTRIC CORP), 6 octobre 1986**

## Description

La présente invention concerne le domaine technique des circuits intégrés et, plus précisément, celui des oscillateurs compensés en température.

Dans la présente description, on définit un oscillateur comme un circuit propre à fournir des signaux périodiques ayant une fréquence prédéterminée qui est sensiblement constante.

Un problème rencontré dans la fourniture d'une telle fréquence réside dans le fait qu'elle varie en fonction de la température avec un coefficient thermique intrinsèque (propre à l'oscillateur), ce qui est préjudiciable quand l'oscillateur est destiné à être utilisé en tant que base de temps.

Il existe dans l'état de la technique un grand nombre d'oscillateurs compensés en température destinés à pallier ce problème, notamment dans les brevets US 5.604.467 et US 5.180.995.

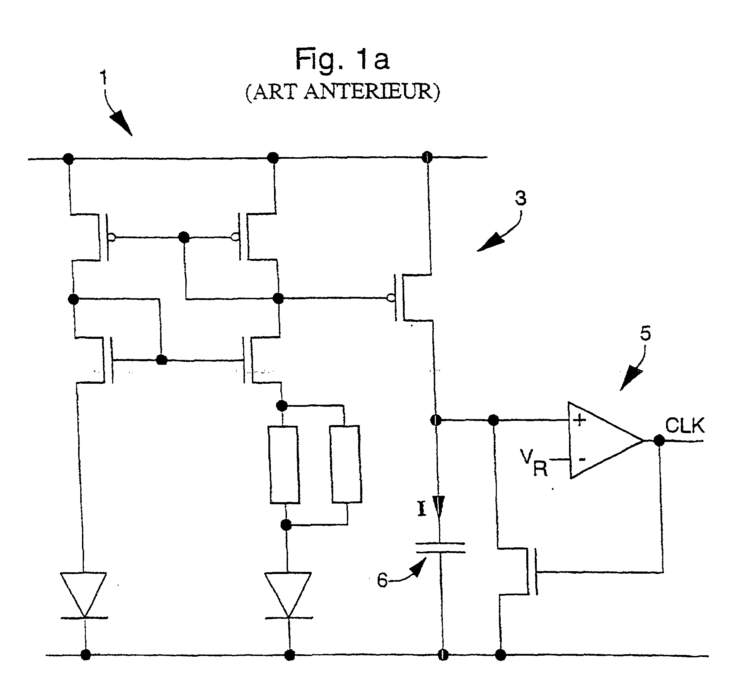

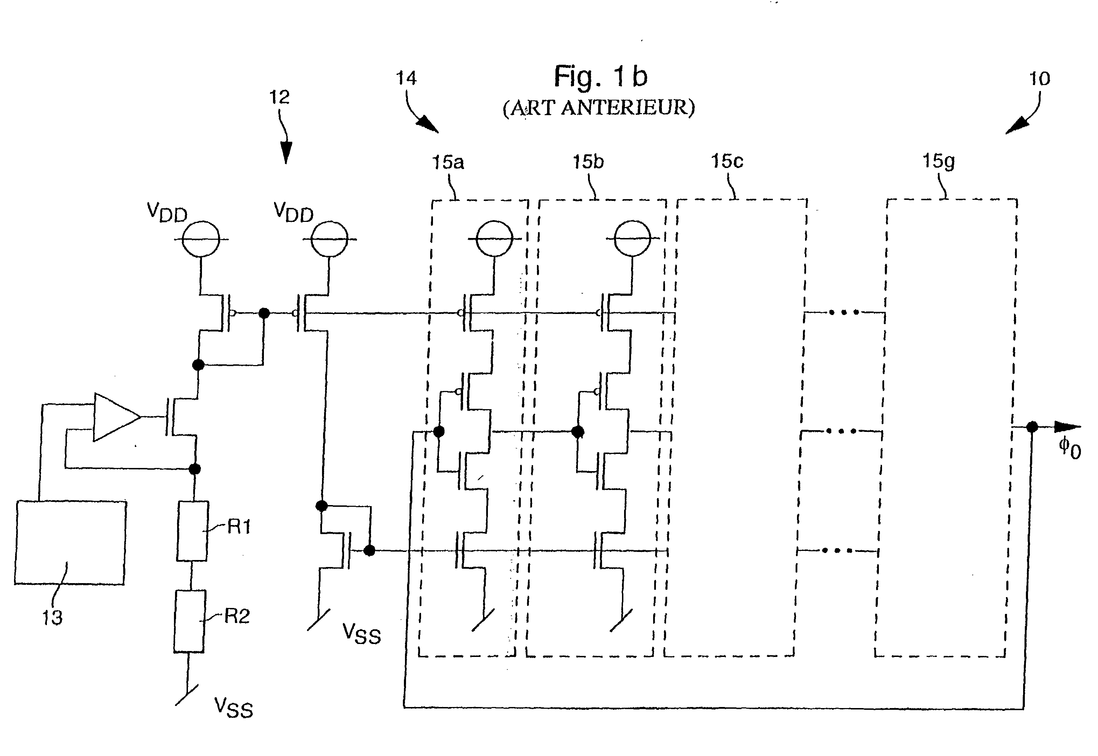

Les figures 1a et 1b de la présente description représentent des oscillateurs 1 et 10 tels que décris dans les brevets US 5.604.467 et US 5.180.995, respectivement.

Comme le représente la figure 1a, l'oscillateur 1 comprend une source de référence 3 et un moyen de fourniture 5. La source de référence 3 est agencée pour fournir un courant I au moyen de fourniture 5, et est compensé en température de sorte que l'intensité du courant I est constante, indépendamment de la température. Le moyen de fourniture 5 comprend un condensateur 6 chargé sous l'injection du courant I, et est agencé pour comparer la tension présente aux bornes de condensateur 6 à une tension de référence Vref, et fournir en réponse un signal périodique CLK.

Un inconvénient d'un tel oscillateur réside dans le fait qu'il ne permet pas de compenser l'influence de la température sur le moyen de fourniture 5, ce dernier ayant un coefficient thermique intrinsèque. Il en résulte que la fréquence du signal CLK peut varier sous l'influence de la température, par l'intermédiaire du coefficient thermique propre au moyen de fourniture 5.

Comme le représente la figure 1b, l'oscillateur 10 comprend un moyen de fourniture 14 pourvu d'inverseurs 15a à 15g et une source de référence 12 pourvue d'un générateur de tension constante 13 et de deux résistances R1 et R2, ces dernières étant formées pour avoir des coefficients thermiques positif et négatif, respectivement. Ainsi, suite à une croissance de la température, la fréquence du signal φo tend à décroître selon les caractéristiques en température de l'oscillateur lui-même et de la résistance R1, et tend à croître la caractéristique en températures de la résistance R2.

Un inconvénient de l'oscillateur 10 réside dans le fait que, pour éviter qu'il se verrouille sur une fréquence parasite, il doit comprendre un nombre premier d'inverseurs (ici 7), ce qui occasionne une surface d'occupation notable.

Un inconvénient de la résistance R2 réside dans le fait qu'elle doit avoir un coefficient thermique négatif, tandis que les résistances fabriquées dans des circuits intégrés ont généralement des coefficients thermiques positifs.

Un autre inconvénient de la résistance R2 réside dans le fait qu'elle est formée dans une zone en silicium polycristallin qui est un matériau ayant une faible résistivité. Ainsi, pour avoir une tension de référence élevée, il est nécessaire soit de former une résistance élevée, ce qui occasionne une surface d'occupation notable, soit de fournir à la source de référence 12 un courant électrique important (typiquement de l'ordre du μA), ce qui occasionne une consommation élevée.

Un objet de la présente invention est de prévoir un oscillateur pouvant compenser l'influence de la température sur l'ensemble des composants de l'oscillateur, de manière à fournir une tension périodique à une fréquence prédéterminée, indépendamment de la température.

Un autre objet de la présente invention est de prévoir un oscillateur qui réponde aux contraintes d'encombrement et de consommation électrique, qui sont habituelles dans l'industrie des circuits intégrés.

Un autre objet de la présente invention est de prévoir un oscillateur réalisable par une filière de fabrication usuelle dans l'industrie des circuits intégrés.

Ces objets, ainsi que d'autres, sont atteints par l'oscillateur selon la revendication 1.

Un avantage de la résistance d'un tel oscillateur est de conférer à la source de référence un coefficient thermique égal à celui du moyen de fourniture, de sorte que la température a une même influence sur cette tension et sur ce moyen. Il en résulte que la fourniture de la tension périodique à la fréquence désirée est indépendante de la température. Autrement dit, la résistance ainsi formée permet une compensation des variations de la fréquence, sous l'influence de la température sur le moyen de fourniture.

Un autre avantage de l'oscillateur selon la présente invention est d'être constitué de composants connus en soi, et pouvant être réalisés de façon monolithique, ce qui répond aux préoccupations d'encombrement et de complexité.

Ces objets, caractéristiques et avantages, ainsi que d'autres, de la présente invention apparaîtront plus clairement à la lecture de la description détaillée d'un mode de réalisation préféré de l'invention, donné à titre d'exemple uniquement, en relation avec les figures jointes, parmi lesquelles :

- les figures 1a et 1b déjà citées représentent deux oscillateurs compensés en température selon l'art antérieur;
- la figure 2 représente un oscillateur selon la présente invention;
- la figure 3 représente un moyen de comparaison de l'oscillateur de la figure 2;
- la figure 4 représente de façon plus détaillée un composant de l'oscillateur de la figure 2;
- la figure 5 représente trois chronogrammes de tensions électriques présentes dans l'oscillateur de la figure 2.

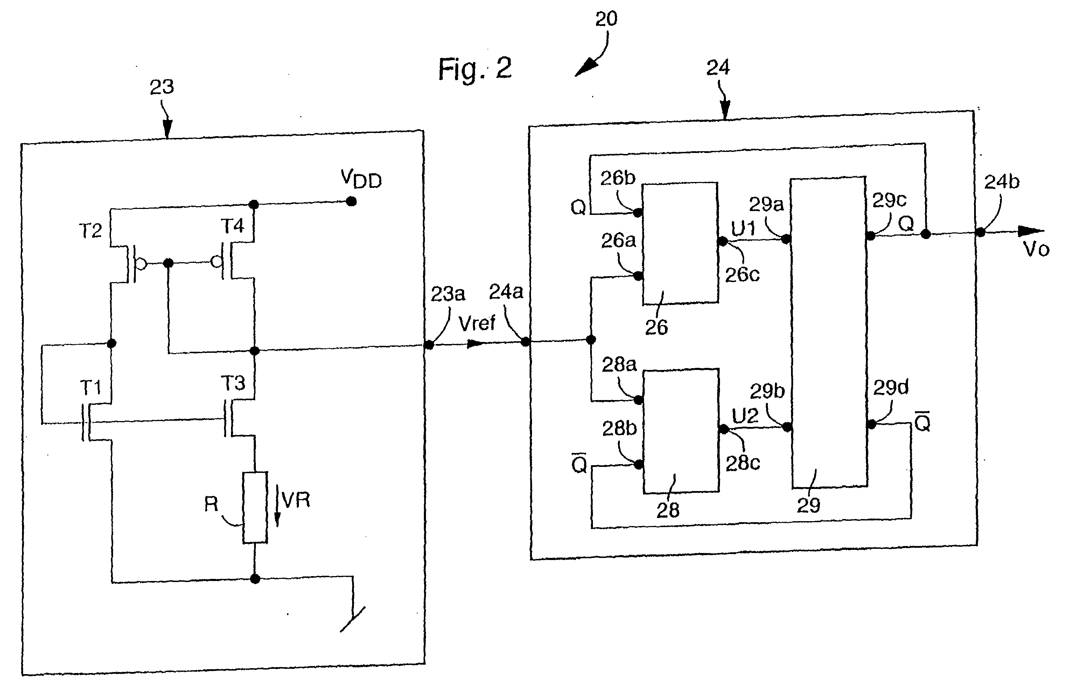

On va décrire un mode de réalisation préféré d'un oscillateur selon la présente invention, à l'aide de la figure 2 qui représente un oscillateur 20 pouvant fournir une tension périodique Vo à une fréquence prédéterminée f.

A cet effet, l'oscillateur 20 comprend une source de référence 23 pouvant fournir une tension de référence Vref, et un moyen de fourniture 24 pouvant recevoir la tension de référence Vref et fournir la tension périodique Vo à la fréquence f.

On note que le moyen de fourniture 24 a un coefficient thermique $\alpha_{24}$ de sorte que la fréquence f peut varier sous l'influence de la température. En ce sens, on définit les variations intrinsèques comme les variations de la fréquence f, sous l'influence de la température sur le moyen de fourniture 24.

La source de référence 23 comprend une borne de sortie 23a connectée au moyen de fourniture 24, pour fournir la tension de référence Vref.

A cet effet, la source de référence 23 comprend quatre transistors à effet de champ T1 à T4 et une résistance R, comme le représente la figure 2. Ces composants sont agencés pour former une source de référence connue en soi, notamment dans l'article intitulé "CMOS Analog Integrated Circuits Based on Weak Inversion Operation", de E. Vittoz et J. Fellrath, paru dans IEEE Journal of Solid States Circuits, Vol. SC-12, No 3, Juin 1977, pp 224 à 231.

On note que la tension présente au point de raccordement entre les transistors T3 et T4 correspond à la tension de référence Vref. On note également que la fourniture de la tension de référence Vref est liée à la résistance R, comme cela est décrit de façon plus détaillée ci-après.

Le moyen de fourniture 24 comprend une borne d'entrée 24a connectée à la borne 23a de la source de référence 23, pour recevoir la tension de référence Vref. Le moyen de fourniture 24 comprend également une borne de sortie 24b, pour fournir la tension périodique Vo.

A cet effet, le moyen de fourniture 24 comprend deux moyens de comparaison 26 et 28 et une bascule 29 connectée en boude avec chacun de ces moyens.

La bascule 29 comprend deux bornes d'entrée 29a et 29b connectées respectivement aux moyens de comparaison 26 et 28, pour recevoir deux tensions de comparaison U1 et U2, respectivement. La bascule 29 comprend également deux bornes de sortie 29c et 29d, pour fournir deux tensions de sortie Q et $\overline{Q}$, respectivement

A cet effet, on réalise de préférence la bascule 29 à partir d'une bascule dite "RS" (provenant de l'acronyme anglais "reset-set") connue en soi.

On note que la borne 24b du moyen de fourniture 24 est connectée, dans cet exemple, à la borne 29c de la bascule 29, de sorte que la tension Vo fournie par l'oscillateur 20 correspond à la tension Q. Il va de soi que la borne 24b du moyen de fourniture 24 peut être connectée à la borne 29d de la bascule 29, au lieu de la borne 29c.

Le moyen de comparaison 26 comprend une borne d'entrée 26a connectée à la borne 24a du moyen de fourniture 24, pour recevoir la tension de référence Vref. Le moyen de comparaison 26 comprend également une borne d'entrée 26b connectée à la borne 29c de la bascule 29, pour recevoir la tension de sortie Q. Le moyen de comparaison 26 comprend également une borne de sortie 26c, connectée à la borne 29a de la bascule 29, pour fournir la tension de comparaison U1. Le moyen de comparaison 26 est agencé pour comparer la tension de référence Vref à une tension liée à la tension Q.

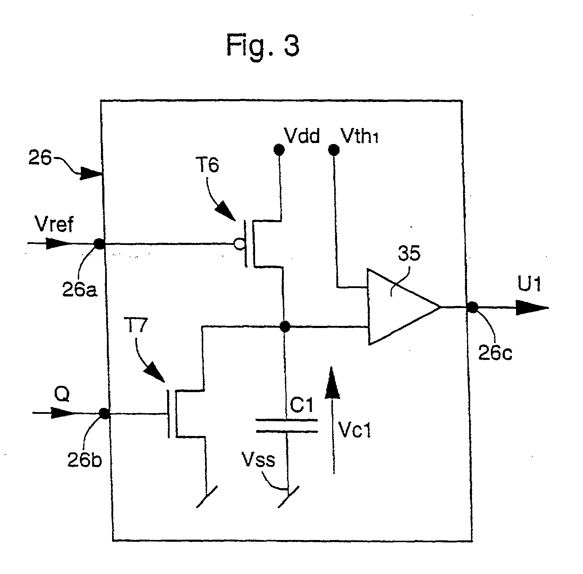

A cet effet, en se référant à la figure 3, le moyen de comparaison 26 comprend un accumulateur C1, un comparateur 35, et deux commutateurs T6 et T7.

L'accumulateur C1 est connecté, d'une part, à la masse du système et, d'autre part, à une borne d'alimentation du système, par l'intermédiaire du commutateur T6, ainsi qu'à la masse du système par l'intermédiaire du commutateur T7. De préférence, l'accumulateur C1 est formé par un condensateur connu en soi. On note que la référence VC1 désigne la tension présente entre les bornes de l'accumulateur C1, et que la référence Vss désigne la tension de masse de l'oscillateur 20, dans la suite de la description.

Les commutateurs T6 et T7 sont connectés pour pouvoir être commandés respectivement par la tension de sortie Q et la tension de référence Vref. De préférence, chacun des commutateurs T6 et T7 est formé par un transistor à effet de champ connu en soi. On note que ces deux transistors sont de type opposé (le transistor T6 étant de type PMOS et le transistor T7 étant de type NMOS. par exemple).

Le comparateur 35 est agencé pour pouvoir recevoir la tension VC1 et une tension de seuil Vth1 fournie par un moyen de fourniture de tension de seuil (non représenté en figure 3). Le comparateur 35 est agencé également pour comparer la tension VC1 et la tension de seuil Vth1, et fournir en réponse la tension de comparaison U1. De préférence, le comparateur 35 est formé par un amplificateur opérationnel connu en soi.

A l'instar du moyen de comparaison 26, on forme le moyen de comparaison 28. Ainsi, le moyen de comparaison 28 comprend notamment un accumulateur ou condensateur C2 et un comparateur 36 pouvant comparer une tension de seuil Vth2 et la tension VC2 présente entre les bornes du condensateur C2.

L'homme du métier note que les différents composants du moyen de fourniture 24 confère à ce dernier un coefficient thermique résultant (c'est-à-dire

$\alpha_{24}$). Ainsi, en supposant que la tension Vref fournie par la source de référence 23 est constante, la tension Vo tendrait à varier sous l'influence de la température, avec un coefficient thermique $\alpha 1$.

Pour pallier cette influence, la source de référence 23 est formée pour avoir un coefficient thermique $\alpha_{23}$ égal au coefficient thermique $\alpha_{24}$, de sorte que la température a la même influence sur la tension de référence Vref et sur le moyen de fourniture 24, ce qui permet la fourniture de la tension périodique Vo indépendamment de la température.

Pour l'essentiel, la résistance R est formée de sorte que le coefficient thermique $\alpha_{23}$ est égal au coefficient thermique $\alpha_{24}$. En ce sens, la résistance R est formée pour avoir un coefficient thermique résultant susceptible de permettre une compensation des variations intrinsèques de la fréquence f, sous l'influence de la température sur le moyen de fourniture 24.

De préférence, on réalise la résistance R à partir d'un ou plusieurs matériaux ayant chacun un coefficient thermique propre, de manière à avoir un coefficient thermique résultant de sorte que le coefficient thermique $\alpha_{23}$ est égal au coefficient thermique $\alpha_{24}$.

A titre illustratif, dans la suite de la description, la résistance R comprend deux résistances R1 et R2 formée respectivement à partir de deux matériaux M1 et M2 ayant respectivement des coefficients thermiques $\alpha 1$ et $\alpha 2$ différents entre eux.

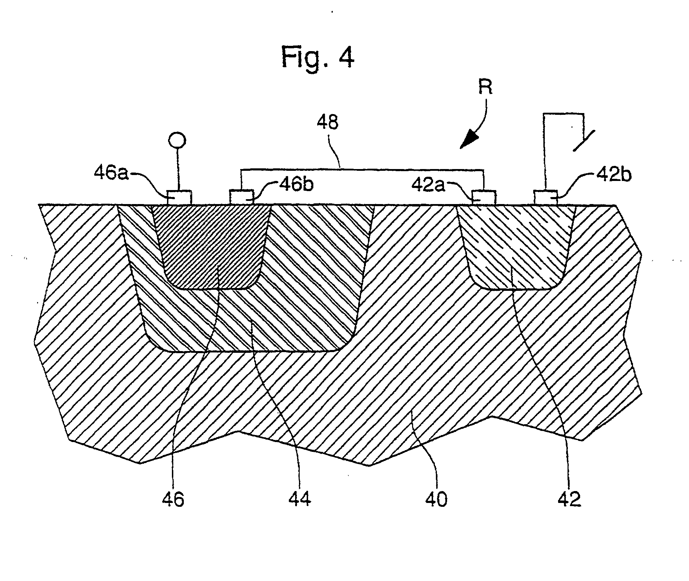

On va maintenant décrire un mode de réalisation préféré de la résistance R, à l'aide de la figure 4 représentant de façon détaillée une vue de coupe de cette résistance.

Comme le représente la figure 4, dans un substrat semi-conducteur 40 qui a un premier type de conductivité faiblement dopé (par exemple P-) est formée une zone de caisson 42, en implantant des impuretés d'un second type de conductivité faiblement dopé (c'est-à-dire N-, en reprenant l'exemple ci-dessus). Ensuite, sur la zone de caisson 42 sont formées deux bornes de connexion 42a et 42b entre lesquelles il existe la résistance R1 ayant le coefficient thermique $\alpha 1$. De même, une autre zone de caisson 44 est formée en implantant des impuretés du second type de conductivité faiblement dopé (c'est-à-dire N-, en reprenant l'exemple ci-dessus). Et, dans la zone de caisson 44 est formée une zone de diffusion 46, en implantant des impuretés du premier type de conductivité fortement dopé (c'est-à-dire P+, en reprenant l'exemple ci-dessus). Ensuite, sur la zone de diffusion 46 sont formées deux bornes de connexion 46a et 46b entre lesquelles il existe la résistance R2 ayant le coefficient thermique $\alpha 2$.

Puis en connectant les bornes 42a et 46b entre elles, par une ligne de connexion 48, les résistances R1 et R2 sont ainsi connectées en série. De façon similaire à la structure représenté en figure 2, la borne 42b est alors mise à la masse de l'oscillateur 20, et la borne 46a est connectée à la borne de source du transistor T3, ce qui réalise la mise en oeuvre des résistances R1 et R2 dans la source de référence 23 en tant que résistance R.

On note dans l'exemple cité ci-dessus que les matériaux M1 et M2 sont respectivement du silicium de type P+ formant une zone de diffusion, et du silicium de type N- formant une zone de caisson.

L'homme du métier note que la source de référence 23 et le moyen de fourniture 24 peuvent être formés de façon monolithique dans un unique substrat semi-conducteur, par un procédé usuel pour fabriquer des circuits intégrés.

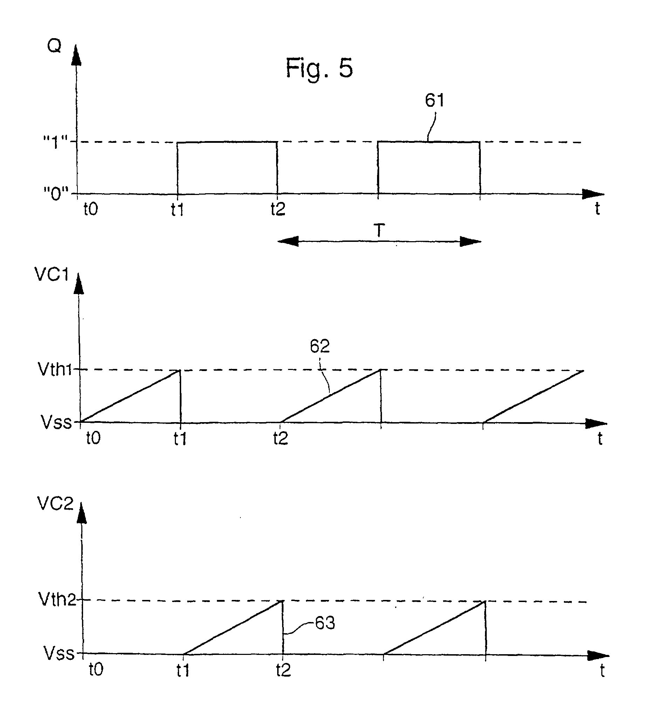

On va maintenant décrire le fonctionnement de l'oscillateur 20, à l'aide de la figure 5 qui représente trois chronogrammes 61 à 63 illustrant les tensions Q, VC1 et VC2, respectivement.

Considérons à un instant initial t0 que la tension Q vaut "0". Le transistor T7 est donc bloqué et le condensateur C1 se charge par l'intermédiaire du transistor T6. Ainsi, la tension VC1 croît linéairement au cours du temps t, comme l'illustre la forme d'onde 62. A un instant t1 ultérieur à l'instant t0, la tension VC1 atteint la tension de seuil Vth1 et, par conséquent, la tension U1 change d'état. En réponse, la tension Q change également d'état, et devient égale à "1".

Dans le cas où la tension Q est égale à "1", le transistor T7 est conducteur, et la tension VC1 est forcée et maintenue à la valeur de la tension Vss. Autrement dit, le condensateur C1 est déchargé. A l'instant t1, la tension Q est donc égale à "0", et la situation pour cette tension est similaire à celle de l'instant t0. Ainsi, à partir de l'instant t1, le condensateur C2 se comporte comme le condensateur C1 se comportait à l'instant t0, comme l'illustre la forme d'onde 63. A un instant t2, la tension VC2 atteint la tension de seuil Vth2 et, par conséquent, la tension U2 change d'état. En réponse, la tension Q change à nouveau d'état, et redevient égale à "0", comme l'illustre la forme d'onde 61. La situation est alors similaire à celle de l'instant t0, et se répète.

On note que la tension Q ainsi fournie a une forme d'onde carrée, l'intervalle de temps entre les instants t0 et t2 définissant la période T de cette tension.

A titre illustratif uniquement, la Demanderesse de la présente invention a mesuré expérimentalement les variations de la fréquence f (liée à la période T) de la tension Q. Elle a mesuré que, quand la fréquence f est égale à 1,2 Mhz, la Demanderesse de la présente invention a mesuré une variation de l'ordre de 0,015 %/°C.

Il va de soi pour l'homme de l'art que la description détaillée ci-dessus peut subir diverses modifications sans sortir du cadre de la présente invention tel qu'il est défini par les revendications. A titre d'exemple, on peut former la résistance de la source de référence, à partir de trois matériaux ayant respectivement trois coefficients thermiques différents.

## Revendications

1. Oscillateur (20) destiné à fournir une tension électrique périodique (Vo) à une fréquence prédéterminée (f), cet oscillateur comprenant :

   - une source de référence (23) pouvant fournir une tension de référence (Vref), cette source de référence comprenant une résistance (R) liée à la fourniture de ladite tension de référence et formée pour conférer à ladite source de référence un premier coefficient thermique ($\alpha_{23}$), ladite résistance comprenant au moins une première résistance formée dans le silicium d'un premier type de conductivité, et
   - un moyen de fourniture (24) pouvant recevoir ladite tension de référence et fournir ladite tension périodique à ladite fréquence prédéterminée, ledit moyen de fourniture ayant un second coefficient thermique ($\alpha_{24}$) égal en valeur absolue au premier coefficient thermique pour que les variations en température de la source de référence compensent les variations en température du moyen de fourniture de sorte que ladite fréquence prédéterminée de la tension périodique reste indépendante de la température,

   cet oscillateur étant **caractérisé en ce que** la résistance (R) comprend une deuxième résistance formée dans le silicium d'un second type de conductivité pour que la connexion des deux résistances confère un premier coefficient thermique à la source de référence égal en valeur absolue au second coefficient thermique du moyen de fourniture.

2. Oscillateur (20) selon la revendication 1, **caractérisé en ce que** la première résistance est formée dans le silicium d'un premier type de conductivité (P) fortement dopé; et **en ce que** la deuxième résistance est formée dans le silicium d'un deuxième type de conductivité (N) faiblement dopé.

3. Oscillateur (20) selon la revendication 1, **caractérisé en ce que** ledit moyen de fourniture (24) comprend des premier et deuxième moyens de comparaison (26, 28) et une bascule (29) connectée en boucle avec chacun de ces moyens, **en ce que** lesdits premier et deuxième moyens de comparaison peuvent recevoir ladite tension de référence (Vref) ainsi que des première et deuxième tensions de sortie respectives ($Q$, $\overline{Q}$), et fournir en réponse des première et deuxième tensions de comparaison respectives (U1, U2), et **en ce que** ladite bascule peut recevoir lesdites première et deuxième tensions de comparaison et fournir en réponse lesdites première et deuxième tensions de sortie, l'une d'entre elles correspondant à ladite tension périodique (Vo).

4. Oscillateur (20) selon la revendication 3, **caractérisé en ce que** ledit premier moyen de comparaison (26) comprend :

   - un premier accumulateur (C1) connecté, d'une part, à la masse du système et, d'autre part, à une borne d'alimentation du système par l'intermédiaire d'un premier commutateur (T6) commandé par ladite première tension de sortie (Q), ainsi qu'à la masse du système par l'intermédiaire d'un deuxième commutateur (T6) commandé par ladite tension de référence (Vref);
   - un premier comparateur (5) pouvant comparer la tension (VC1) présente entre les bornes dudit premier accumulateur, et une première tension de seuil (Vth1) fournie par un premier moyen de fourniture de tension de seuil, et fournir en réponse ladite première tension de comparaison (U1).

5. Oscillateur (20) selon la revendication 3, **caractérisé en ce que** ledit deuxième moyen de comparaison (28) comprend :

   - un deuxième accumulateur (C2) connecté, d'une part, à la masse du système et, d'autre part, à une borne d'alimentation du système par l'intermédiaire d'un troisième commutateur commandé par ladite deuxième tension de sortie ($\overline{Q}$), ainsi qu'à la masse du système par l'intermédiaire d'un quatrième commutateur commandé par ladite tension de référence (Vref);
   - un premier comparateur pouvant comparer la tension (VC2) présente entre les bornes dudit deuxième accumulateur, et une deuxième tension de seuil (Vth2) fournie par un premier moyen de fourniture de tension de seuil, et fournir en réponse ladite deuxième tension de comparaison (U1).

6. Oscillateur (20) selon la revendication 1, **caractérisé en ce que** ladite source de référence (23) et ledit moyen de fourniture (24) sont formés de façon monolithique dans un unique substrat semi-conducteur.

## Patentansprüche

1. Oszillator (20), der dazu bestimmt ist, eine periodische elektrische Spannung (Vo) mit einer vorgegebenen Frequenz (f) zu liefern, wobei dieser Oszillator umfaßt:

   - eine Referenzquelle (23), die eine Referenzspannung (Vref) liefern kann, wobei diese Referenzquelle einen Widerstand (R) aufweist, der mit der Liefereinrichtung der Referenzspannung verbunden und so ausgebildet ist, daß er der Referenzquelle einen ersten Wärmekoeffizienten ($\alpha_{23}$) verleiht, wobei der Widerstand wenigstens einen im Silicium eines ersten Leitungstyps gebildeten Widerstand umfaßt, und

- ein Liefermittel (24), das die Referenzspannung empfangen und die periodische Spannung mit der vorgegebenen Frequenz liefern kann, wobei das Liefermittel einen zweiten Wärmekoeffizienten ($\alpha_{24}$) besitzt, der dem Absolutwert nach gleich dem ersten Wärmekoeffizienten ist, damit die Temperaturschwankungen der Referenzquelle die Temperaturschwankungen der Lieferquelle kompensieren, derart, daß die vorgegebene Frequenz der periodischen, Spannung von der Temperatur unabhängig bleibt,

wobei dieser Oszillator **dadurch gekennzeichnet ist, daß** der Widerstand R einen im Silicium eines zweiten Leitungstyps gebildeten zweiten Widerstand umfaßt, damit die Verbindung der beiden Widerstände der Referenzquelle einen ersten Wärmekoeffizienten verleiht, der dem Absolutwert nach gleich dem zweiten Wärmekoeffizienten des Liefermittels ist.

2. Oszillator (20) nach Anspruch 1, **dadurch gekennzeichnet, daß** der erste Widerstand im Silicium eines stark dotierten ersten Leitungstyps (P) gebildet ist; und daß der zweite Widerstand im Silicium eines schwach dotierten zweiten Leitungstyps (N) gebildet ist.

3. Oszillator (20) nach Anspruch 1, **dadurch gekennzeichnet, daß** das Liefermittel (24) erste und zweite Vergleichsmittel (26, 28) und eine mit jedem dieser Mittel in einer Schleife verbundene Kippschaltung (29) umfaßt, daß die ersten und zweiten Vergleichsmittel die Referenzspannung (Vref) sowie die ersten und zweiten Ausgangsspannungen (Q, $\bar{Q}$) empfangen können und als Antwort darauf eine erste bzw. eine zweite Vergleichsspannung (U1, U2) liefern, und daß die Kippschaltung die erste und die zweite Vergleichsspannung empfangen kann und als Antwort darauf die erste und die zweite Ausgangsspannung liefern kann, wovon eine der periodischen Spannung (Vo) entspricht.

4. Oszillator (20) nach Anspruch 3, **dadurch gekennzeichnet, daß** das erste Vergleichsmittel (26) umfaßt:

- einen ersten Akkumulator (C1), der einerseits mit der Masse des Systems und andererseits mit einem Versorgungsanschluß des Systems über einen ersten Kommutator (T6), der durch die erste Ausgangsspannung (Q) gesteuert wird, sowie mit der Masse des Systems über einen zweiten Kommutator (T6), der durch die Referenzspannung (Vref) gesteuert wird, verbunden ist;

- einen ersten Komparator (5), der die zwischen den Anschlüssen des ersten Akkumulators anliegende Spannung (VC1) mit einer ersten Schwellenspannung (Vth1), die von einem ersten Mittel zum Liefern einer Schwellenspannung geliefert wird, vergleichen und als Antwort darauf die erste Vergleichsspannung (U1) liefern kann.

5. Oszillator (20) nach Anspruch 3, **dadurch gekennzeichnet, daß** das zweite Vergleichsmittel (28) umfaßt:

- einen zweiten Akkumulator (C2), der einerseits mit der Masse des Systems und andererseits mit einem Versorgungsanschluß des Systems über einen dritten Kommutator, der durch die zweite Ausgangsspannung ($\bar{Q}$) gesteuert wird, sowie mit der Masse des Systems über einen vierten Kommutator, der durch die Referenzspannung (Vref) gesteuert wird, verbunden ist;

- einen ersten Komparator, der die Spannung (VC2), die zwischen den Anschlüssen des zweiten Akkumulators anliegt, mit einer zweiten Schwellenspannung (Vth2), die von einem ersten Mittel zum Liefern einer Schwellenspannung geliefert wird, vergleichen und als Antwort darauf die zweite Vergleichsspannung (U1) liefern kann.

6. Oszillator (20) nach Anspruch 1, **dadurch gekennzeichnet, daß** die Referenzquelle (23) und das Liefermittel (24) in einem einzigen Halbleitersubstrat monolithisch ausgebildet sind.

**Claims**

1. Oscillator (20) intended to supply a periodic electric voltage (Vo) at a predetermined frequency (f), said oscillator including:

- a reference source (23) able to provide a reference voltage (Vref), this reference source including a resistor (R) linked to the supply of said reference voltage and formed to give said reference source a first temperature coefficient ($\alpha_{23}$), said resistor including at least a first resistor formed in silicon of a first type of conductivity, and

- supply means (24) able to receive said reference voltage and to supply said periodic voltage at said predetermined frequency, said supply means having a second temperature coefficient ($\alpha_{24}$) equal in absolute value to the first temperature coefficient so that the temperature variations of the reference source compensate for the temperature variations of the supply means so that said predetermined frequency of the periodic voltage remains independent of the temperature,

said oscillator being **characterised in that** the resistor (R) includes a second resistor formed in silicon of a second type of conductivity so that the connection of two resistors gives the reference source a first temperature coefficient equal in absolute value to the second temperature coefficient of the supply means.

2. Oscillator (20) according to claim 1, **characterised in that** the first resistor is formed in silicon of a first type of highly doped conductivity (P); and **in that** the second resistor is formed in silicon of a second type of lightly doped conductivity (N).

3. Oscillator (20) according to claim 1, **characterised in that** said supply means (24) include first and second comparison means (26, 28) and a flip-flop (29) connected in a loop with each of said means, **in that** said first and second comparison means can receive said reference voltage (Vref) as well as first and second respective output voltages (Q, $\overline{Q}$), and supply in response first and second respective comparison voltages (U1, U2), and **in that** said flip-flop can receive said first and second comparison voltages and provide in response said first and second output voltages, one of them corresponding to said periodic voltage (Vo).

4. Oscillator (20) according to claim 3, **characterised in that** said first comparison means (26) includes:

   - a first accumulator (C1) connected, on the one hand, to the system's earth, and on the other hand to a supply terminal of the system via a first switch (T6) controlled by said first output voltage (Q), as well as to the system's earth via a second switch (T7) controlled by said reference voltage (Vref);
   - a first comparator (5) able to compare the voltage (VC1) present across the terminals of said first accumulator, and a first threshold voltage (Vth1) supplied by first threshold voltage supply means, and to supply in response said first comparison voltage (U1).

5. Oscillator (20) according to claim 3, **characterised in that** said second comparison means (28) include:

   - a second accumulator (C2) connected, on the one hand, to the system's earth and on the other hand, to a supply terminal of the system via a third switch controlled by said second output voltage ($\overline{Q}$), as well as to the system's earth via a fourth switch controlled by said reference voltage (Vref);
   - a first comparator able to compare the voltage (VC2) present across the terminals of said second accumulator, and a second threshold voltage (Vth2) supplied by first threshold voltage supply means, and to supply in response said second comparison voltage (U1).

6. Oscillator (20) according to claim 1, **characterised in that** said reference source (23) and said supply means (24) are formed in a monolithic manner in a single semiconductor substrate.

# Fig. 1a
## (ART ANTERIEUR)

Fig. 1 b
(ART ANTERIEUR)

Fig. 2

# Fig. 3

## Fig. 4

# Fig. 5